**Europäisches Patentamt**

**European Patent Office**

**Office européen des brevets**

(19)

(11) Veröffentlichungsnummer: **0 342 274**
B1

(12) # EUROPÄISCHE PATENTSCHRIFT

(45) Veröffentlichungstag der Patentschrift:
**08.08.90**

(21) Anmeldenummer: **88121333.4**

(22) Anmeldetag: **21.12.88**

(51) Int. Cl.⁵: **H01L 43/04**, G01L 1/18

(54) Anordnung zur Verminderung von Piezoeffekten in mindestens einem in einem Halbleitermaterial angeordneten piezoeffekt-empfindlichen elektrischen Bauelement und Verfahren zur Herstellung dieser Anordnung.

(30) Priorität: **26.04.88 CH 1560/88**

(43) Veröffentlichungstag der Anmeldung:
**23.11.89 Patentblatt 89/47**

(45) Bekanntmachung des Hinweises auf die Patenterteilung:
**08.08.90 Patentblatt 90/32**

(84) Benannte Vertragsstaaten:
**CH DE FR GB IT LI**

(56) Entgegenhaltungen:
**EP-A- 59 796**
**EP-A- 171 056**
**EP-A- 237 280**

(73) Patentinhaber: **Landis & Gyr Betriebs AG,**
**CH-6301 Zug(CH)**

(72) Erfinder: **Beat, Hälg, Loretohöhe 5, CH-6300 Zug(CH)**
Erfinder: **Radivoje, Popovic, Fridbach 1,**
**CH-6300 Zug(CH)**

## Beschreibung

Die Erfindung bezieht sich auf eine Anordnung zur Verminderung von Piezoeffekten in mindestens einem in einem Halbleitermaterial angeordneten piezoeffekt-empfindlichen elektrischen Bauelement und auf ein Verfahren zur Herstellung dieser Anordnung gemäss dem Oberbegriff des Anspruchs 1 bzw. eines der Ansprüche 15 bis 17.

Die Parameter sämtlicher in Halbleitermaterial hergestellter elektrischer Bauelemente sind abhängig vom mechanischen Spannungszustand dieses Halbleitermaterials. Dieses als Piezoeffekt bekannte Phänomen ist z.B. in Widerständen und Hallelementen besonders ausgeprägt. Bei Verwendung solcher piezoeffekt-empfindlicher Bauelemente in Präzisionsinstrumenten, wie z.B. in Elektrizitätszählern ergeben sich Genauigkeits- und Langzeitstabilitäts-Probleme, welche vor allem beim Einbau in integrierten Schaltungen nicht ohne weiteres gelöst werden können. Die Montage von Halbleiterkristallen ("chips") in einem Gehäuse und/oder auf einem mechanischen Träger führt nämlich zu schwierig kontrollierbaren thermo-mechanischen Spannungen und damit zu unerwünschten Piezoeffekten. Dadurch können wichtige Parameter der verwendeten Bauelemente Werte annehmen, welche nicht den berechneten oder gewünschten Werten entsprechen. Zudem können die Parameterwerte wegen den unterschiedlichen thermischen und/oder mechanischen Spannungen von Kristall zu Kristall breiten Streuungen und im Laufe der Zeit wegen einer Abwanderung des Spannungszustandes grossen Änderungen unterliegen, die zu Genauigkeits- und Langzeitstabilitätsproblemen führen.

Aus den Druckschriften bzw. aus dem Buch
- Phys. stat. sol. (a) 35, K115 bis K118 (1976), "Effect of mechanical stress on the offset voltage of Hall devices in Si IC", Y. Kanda and M. Migitaka,
- Phys. stat. sol. (a) 38, K41 bis K44 (1976), "Design Consideration for Hall devices in Si IC", Y. Kanda and M. Migitaka,
- RCA Review, Vol 43, Dec 1982, Seiten 590 bis 607, "Piezoresistivity Effects in Plastic-Encapsulated Integrated Circuits", K.M.Schlesier, S.A. Keneman and R.T. Mooney, und
- "Hybridintegration, Technologie und Entwurf von Dickschichtschaltungen", Hüthig-Verlag, Heidelberg, 1986, Seiten 214 bis 217, M. Feil, A. Kolbeck, P. Lenk, H. Reichl und E. Ziegler
ist bekannt, dass Piezoeffekte minimiert werden können
- durch eine optimale Auswahl der Kristallorientierung (100), (110) oder (111) des Halbleiter-Grundmaterials ("Wafermaterials"),
- durch eine optimale Auswahl der räumlichen Richtungen der kritischen Bauelemente relativ zum Kristallgitter des verwendeten Halbleiter-Grundmaterials oder
- durch Verwendung einer entsprechenden Montageart des Halbleiterkristalls ("chip"), z. B. mit Hilfe eines sogenannten "Flip-Chip-Bondings".

Der Erfindung liegt die Aufgabe zugrunde, eine Anordnung zu finden, die die negativen Einflüsse montagebedingter Piezoeffekte, insbesondere deren negativen Einfluss auf die Genauigkeit und die Langzeitstabilität einer aus Halbleiterbauelementen hergestellten elektronischen Präzisionsschaltung, annulliert oder mindestens stark reduziert. Die erfindungsgemässe Anordnung dient somit zur mechanischen Isolation der piezoeffekt-empfindlichen elektrischen Bauelemente und damit zur weitgehenden Befreiung derselben von montagebedingten thermo-mechanischen Spannungen.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen, wobei mindestens eine Erfindungsvariante den weiteren Vorteil hat, dass verschiedene Bauelemente einer integrierten Schaltung elektrisch perfekt gegeneinander isoliert sind, so dass die verschiedenen Bauelemente sich wegen einer unvollkommenen elektrischen Isolation nicht in ihrer Funktion negativ beeinflussen können.

Ausführungsbeispiele der Erfindung sind in der Zeichnung dargestellt und werden im folgenden näher beschrieben.

Gleiche Bezugszeichen bezeichnen in allen Figuren der Zeichnung gleiche Teile.

Es zeigen:

Fig. 1 eine erste Variante der erfindungsgemässen Anordnung,
Fig. 2 eine zweite Variante der erfindungsgemässen Anordnung,
Fig. 3 eine dritte Variante der erfindungsgemässen Anordnung,
Fig. 4 eine vereinfachte schematische Draufsicht einer vierte Variante der erfindungsgemässen Anordnung,
Fig. 5 ein vereinfachter schematischer Querschnitt der vierten Variante der erfindungsgemässen Anordnung und
Fig. 6a bis Fig. 6e eine vereinfachte schematische Darstellung der verschiedenen Verfahrensschritte bei einer möglichen Herstellung der vierten Variante der erfindungsgemässen Anordnung.

Die in der Zeichnung wiedergegebenen Darstellungen erheben keinen Anspruch auf Vollständigkeit. Insbesondere sind keine Anschlüsse, Kontaktierungen und Verdrahtungen dargestellt.

In allen vier Varianten enthält die erfindungsgemässe Anordnung eine Schicht Halbleitermaterial 1, eine Schicht Trägermaterial 2 und mindestens ein piezoeffekt-empfindliches elektrisches Bauelement 3, wobei eine Schicht jeweils auch aus einem Plättchen bestehen kann. Das Halbleitermaterial 1 ist z.B. ein Siliziumplättchen ("chip") und das Trägermaterial 2 ein Keramiksubstrat. Beim Vorhandensein mehrerer zusammengehöriger elektrischer Bauelemente bilden diese zusammen vorzugsweise eine elektrische Schaltungsanordnung oder eine integrierte Schaltung. Die Schicht Halbleitermaterial 1 ist räumlich immer bedeutend grösser als der von allen piezoeffekt-empfindlichen elektrischen Bauelementen 3 belegte Platz. Dieser Platz ist in der Zeichnung durch eine Fläche dargestellt, die durch eine gestrichelte Linie umgeben ist. Alle zusammengehörigen elektrischen Bauelemente 3 sind jeweils in einem räumlich eingeschränkten Teil des Halbleitermaterials 1 konzentriert angeordnet, so dass nur ein Teil des Halbleitermaterials 1 mit dem piezoeffekt-empfindlichen Bauelement 3 bzw. den zusammengehörigen piezoeffekt-empfindlichen Bauelementen 3 belegt ist. Das Halbleitermaterial 1 ist jeweils entlang einer Auflagefläche auf dem Trägermaterial 2 montiert, d. h. geklebt oder eutectisch mit Hilfe eines Metalls verbunden ("bonded"). Zwischen dem Teil des Halbleitermaterials 1, welches mit dem piezoeffekt-empfindlichen elektrischen Bauelement 3 bzw. mit den zusammemgehörigen piezoeffekt-empfindlichen Bauelementen 3 belegt ist, und dem zugehörigen Teil des Trägermaterials 2 ist jeweils ein Zwischenraum 4 derart vorhanden, dass der Teil des Halbleitermaterials 1, welches mit dem piezoeffekt-empfindlichen elektrischen Bauelement 3 bzw. mit den zusammengehörigen 5 piezoeffekt-empfindlichen elektrischen Bauelementen 3 belegt ist, eine gemeinsame Auflagefläche zwischen Halbleitermaterial 1 und Trägermaterial 2 balkonartig überragt. In allen Varianten ist 5 zwischen dem Halbleitermaterial 1 und dem Trägermaterial 2 eine dünne Schicht aus Verbindungsmaterial 5 vorhanden, wobei das Verbindungsmaterial 5 entweder ein Kleber oder ein Metall, wie z. B. Gold, ist. In der ersten und zweiten Variante der erfindungsgemässen Anordnung weist mindestens der Teil des Halbleitermaterials 1, der durch das piezoeffekt-empfindliche elektrische Bauelement 3 bzw. durch die piezoeffekt-empfindlichen Bauelemente 3 belegt ist, vorzugsweise eine annähernd konstante Dicke auf.

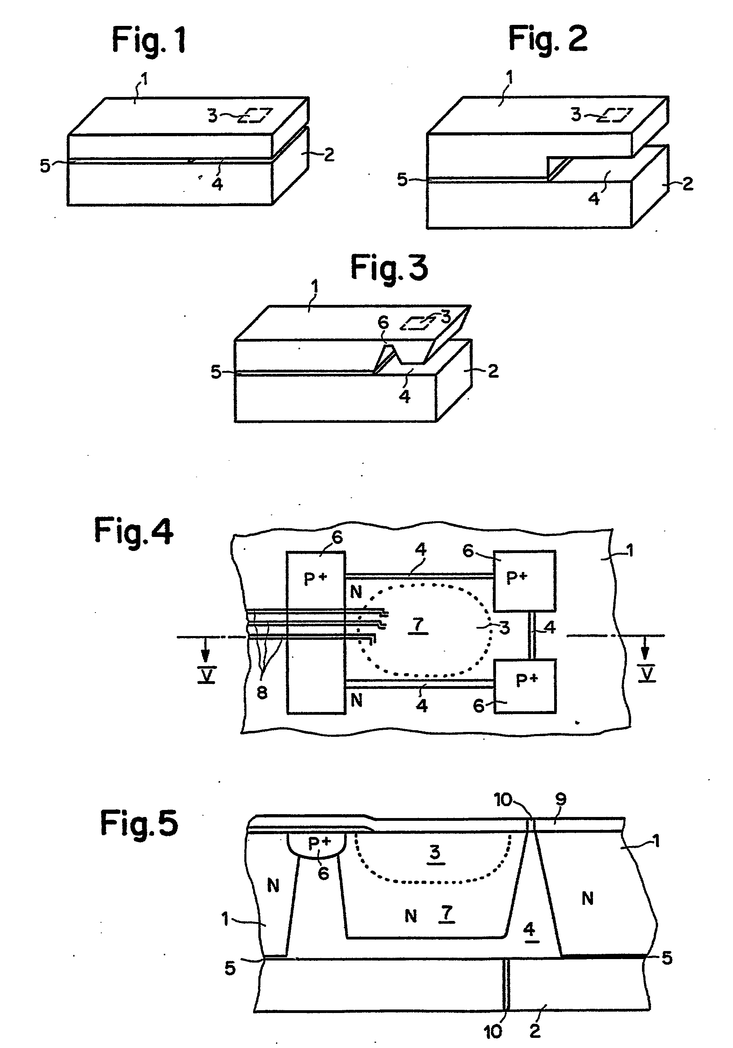

Die gemäss Fig. 1 in der ersten Variante der erfindungsgemässen Anordnung vorhandenen Schichten aus Halbleitermaterial 1 und Trägermaterial 2 weisen beide je eine annähernd konstante Dicke von z. B. 0,3 mm bis 2 mm auf. Zwischen diesen beiden Schichten ist teilweise die dünne Schicht Verbindungsmaterial 5 angeordnet, die ebenfalls eine annähernd konstante Dicke aufweist und durch die das Halbleitermaterial 1 entlang einer gemeinsamen Auflagefläche auf dem Trägermaterial 2 montiert ist. Das Verbindungsmaterial 5 ist dabei nur zwischen einem Teil des Trägermaterials 2 und einem zugehörigen Teil des Halbleitermaterials 1 angeordnet, der ausserhalb desjenigen Teils des Halbleitermaterials 1 gelegen ist, der das piezoeffekt-empfindliche elektrische Bauelement 3 bzw. die piezoeffekt-empfindlichen elektrischen Bauelemente 3 enthält. Die Schicht aus Verbindungsmaterial 5 besitzt in der Regel eine Dicke von mindestens 1µm. Der keine Bauelemente 3 enthaltende Teil des Halbleitermaterials 1 ist somit fest auf dem als Unterlage dienenden Trägermaterial 2 montiert, während der andere Teil des Halbleitermaterials 1, welcher das Bauelement 3 bzw. die Bauelemete 3 enthält, nicht direkt mit dem Trägermaterial 2 verbunden, sondern von diesem durch den Zwischenraum 4 getrennt ist, der eine annähernd konstante und gleich grosse Dicke aufweist wie die Schicht aus Verbindungsmaterial 5.

Die in der Fig. 2 dargestellte zweite Variante der erfindungsgemässen Anordnung unterscheidet sich von der ersten Variante nur dadurch, dass der Teil des Halbleitermaterials 1, der das piezoeffekt-empfindliche elektrische Bauelement 3 bzw. die zusammengehörigen piezoeffekt-empfindlichen elektrischen Bauelemente 3 enthält, mindestens leicht dünner ist als der übrige Teil des Halbleitermaterials 1. Derjenige Teil des Halbleitermaterials 1, der das piezoeffekt-empfindliche elektrische Bauelement 3 bzw. die zusammengehörigen piezoeffekt-empfindlichen elektrischen Bauelemente 3 enthält, hat keinen direkten Kontakt mit dem als Unterlage dienenden Trägermaterial 2 und ist durch den Zwischenraum 4, der vorzugsweise wieder eine konstante Dicke aufweist, vom Trägermaterial 2 getrennt. Der dickere Teil des Halbleitermaterials 1 ist über das Verbindungsmaterial 5 mit dem Trägermaterial 2 verbunden, wobei das Verbindungsmaterial 5 wieder nur entlang der Auflagefläche zwischen einem Teil des Trägermaterials 2 und einem zugehörigen Teil des Halbleitermaterials 1 angeordnet ist, der ausserhalb desjenigen Teils des Halbleitermaterials 1 gelegen ist, der das piezoeffekt-empfindliche elektrische Bauelement 3 bzw. die piezoeffekt-empfindlichen elektrischen Bauelemente 3 enthält.

Die in der Fig. 3 dargestellte dritte Variante der erfindungsgemässen Anordnung unterscheidet sich von der zweiten Variante nur dadurch, dass der mindestens leicht dünnere, das piezoeffekt-empfindliche elektrische Bauelement 3 bzw. die zusammengehörigen piezoeffekt-empfindlichen elektrischen Bauelemente 3 enthaltende Teil des Halbleitermaterials 1 nicht, wie in der Fig. 2 dargestellt, direkt, sondern nur über mindestens einen Zwischensteg 6 mit dem übrigen Teil des Halbleitermaterials 1, d. h. mit dem dickeren, keine piezoeffekt-empfindlichen Bauelemente 3 enthaltenden Teil des Halbleitermaterials 1 verbunden ist, der seinerseits wieder mit Hilfe des Verbindungsmaterials 5 auf das Trägermaterial 2 montiert ist. Der Zwischensteg 6 ist bedeutend dünner als der Teil des Halbleitermaterials 1, der durch das piezoeffekt-empfindliche elektrische Bauelement 3 bzw. durch die piezoeffekt-empfindlichen elektrischen Bauelementen 3 belegt ist. Das Halbleitermaterial 1 wird somit durch den stark verjüngten Zwischensteg 6 in mindestens zwei Teilen unterteilt, wobei nur einer der beiden Teile auf dem Trägermaterial 2 fest montiert ist, während der andere Teil, der mindestens eines der piezoeffekt-empfindlichen elektrischen Bauelemente 3 enthält, balkonartig den Zwischenraum 4 überragt. Sowohl der balkonartig überragende Teil des Halbleitermaterials 1 als auch der Zwischenraum 4 besitzen in der dritten Variante der erfindungsgemässen Anordnung jeweils keine konstante Dicke mehr. Die räumlichen Übergänge zwischen den Teilen unterschiedlicher Dicke des Halbleitermaterials 1 sind an sich in der zweiten und dritten Variante von beliebiger Gestalt. In der Fig. 2 ist der Übergang ideal angenommen, indem der Wechsel sprunghaft vom dünneren zum dickeren Teil erfolgt. In der Fig. 3 sind die Übergänge sowohl vom dickeren als auch vom dünneren Teil des Halbleitermaterials 1 zum Zwischensteg 6 ideal linear angenommen, so dass trapezförmige Querschnitte vorhanden sind.

In der Praxis wird die Gestalt dieser Übergänge dagegen eher zufällig durch das verwendete Herstellungsverfahren bestimmt, welches in der Regel mindestens ein Ätzverfahren beinhaltet.

Die in den Figuren 4 und 5 dargestellte vierte Variante wird vorzugsweise in integrierten Schaltungen verwendet und ähnelt der dritten Variante, mit dem Unterschied, dass durch einen oder 8 mehreren Zwischenstege 6 nicht mehr die ganze Schicht Halbleitermaterial 1 in mindestens zwei Teilen geteilt wird, sondern dass im Halbleitermaterial 1 einzelne isolierte Parzellen 7 vorhanden sind, die jeweils durch das piezoeffekt-empfindliche elektrische Bauelement 3 bzw. durch die zusammengehörigen piezoeffekt-empfindlichen elektrischen Bauelemente 3 belegt sind und die mindestens leicht dünner sind als der übrige Teil des Halbleitermaterials 1, der seinerseits so auf das Trägermaterial 2 montiert ist, dass zwischen jeder Parzelle 7 und dem zugehörigen Trägermaterial 2 ein Zwischenraum 4 vorhanden ist. Jede Parzelle 7 ist ausserdem seitlich nach allen Richtungen mindestens teilweise von dem Zwischenraum 4 umgeben, der sie somit sowohl vom Trägermaterial 2 als auch mindestens teilweise vom übrigen Halbleitermaterial 1 trennt. Die mechanische Verbindung der Parzelle 7 zum übrigen Teil des Halbleitermaterials 1 übernimmt mindestens ein die Parzelle 7 mindestens teilweise seitlich umgebender Zwischensteg 6, der bedeutend dünner als die Parzelle 7 ist. Jeder Zwischensteg 6 ist vorzugsweise als Wanne an der Oberfläche des Halbleitermaterials 1 eindiffundiert, wobei das Halbleitermaterial 1 und die Wannen vom entgegengesetzten Leitfähigkeitstyp sind. Wenn die Parzelle 7 seitlich nur teilweise von dem Zwischensteg 6 umgeben ist, dann ist sie für den verbleibenden Rest seitlich durch den Zwischenraum 4 vom restlichen Halbleitermaterial 1 getrennt.

In den Figuren 4 und 5 ist nur eine einzige isolierte Parzelle 7 dargestellt, die über drei Zwischenstege 6 mit dem restlichen Teil des Halbleitermaterials 1 verbunden ist. In der vierten Variante ist vorzugsweise das Trägermaterial 2 ein Substrat, auf dessen Oberfläche das Halbleitermaterial 1, z. B. vom Leitfähigkeitstyp N, angeordnet ist. Die Parzelle 7 ist, wie bereits erwähnt, leicht dünner als der restliche Teil des Halbleitermaterials 1, welcher seinerseits wieder über eine Schicht Verbindungsmaterial 5 auf dem Trägermaterial 2 montiert ist, so dass zwischen der Parzelle 7 und dem Trägermaterial 2 der Zwischenraum 4 vorhanden ist. Im Halbleitermaterial 1 befindet sich wie eine Insel die isolierte Parzelle 7, die ebenfalls aus Halbleitermaterial vom Leitfähigkeitstyp N besteht und in der alle zusammengehörigen piezoeffekt-empfindlichen Bauelemente 3 angeordnet sind. Die isolierte Parzelle 7 ist nach unten und seitlich nach allen Richtungen durch den Zwischenraum 4 umgeben, der nach oben hin teilweise offen und teilweise durch die dünnen Zwischenstege 6 geschlossen ist. Diese dünnen Zwischenstege 6 sind an der Oberfläche des Zwischenraums 4 vorhanden, zwecks Gewährleistung des mechanischen Haltes der isolierten Parzelle 7 durch seitliche mechanische Verbindungen der isolierten Parzelle 7, an das restliche Halbleitermaterial. Die Zwischenstege 6 sind, wie bereits erwähnt, vorzugsweise Wannen aus P+-Material, die am äusseren Rand der Oberfläche der isolierten Parzelle 7 in das Halbleitermaterial 1 eindiffundiert sind und die bedeutend dünner sind als die isolierte Parzelle 7. An der Oberfläche des Halbleitermaterials 1 ist das piezoeffekt-empfindliche elektrische Bauelement 3 bzw. sind die zusammengehörigen piezoeffekt-empfindlichen elektrischen Bauelemente 3 der isolierten Parzelle 7 jeweils über Leiterbahnen 8, die vorzugsweise als Metallisierung auf der Oberfläche des Halbleitermaterials 1 aufgetragen sind, entweder mit nicht mehr dargestellten Gehäuseanschlüssen der Anordnung oder mit benachbarten Anordnungen der gleichen integrierten Schaltung elektrisch verbunden. Die gesamte Anordnung mit ihren Leiterbahnen 8 ist in der Regel nach oben hin mit mindestens einer Passivierungsschicht 9 aus $SiO_2$- und/oder $Si_3N_4$-Material bedeckt.

In einer Zone rund um die piezoeffekt-empfindlichen elektrischen Bauelemente 3 bzw. deren elektrische Schaltung ist somit das Halbleitermaterial 1 von der Rückseite her stark verjüngt, so dass die getrennte und isolierte Parzelle 7 aus Halbleitermaterial 1 besteht, welches nur noch durch wohldefinierte, verhältnismässig dünne Zwischenstege 6 an der 10 Oberfläche mit dem restlichen Halbleitermaterial 1 verbunden ist. Zusätzlich ist die isolierte Parzelle 7 von der Waferrückseite her gegenüber der übrigen, ursprünglichen Dicke des Halbleitermaterials 1 leicht verjüngt. Der Zwischenraum 4 ist zum Druckausgleich vorzugsweise nach oben hin über Druckausgleichöffnungen 10 offen. Druckausgleichöffnungen 10 können aber auch nach unten hin im Trägermaterial 2 angeordnet sein. Die isolierte Parzelle 7 überragt den Zwischenraum 4 wie ein Balkon, der mittels der drei Wannen aus P+-Material am restlichen Teil des Halbleitermaterials 1 aufgehängt ist.

Trotz der Montage des Halbleitermaterials 1 auf das Trägermaterial 2 bleibt in allen vier Varianten der Teil des Halbleitermaterials 1, der mit dem piezoeffekt-empfindlichen elektrischen Bauelement 3 bzw. mit den zusammegehörigen piezoeffekt-empfindlichen elektrischen Bauelementen 3 belegt ist, dank des Vorhandenseins des Zwischenraums 4 weitgehend frei von inneren mechanischen Spannungen und die darin enthaltenen piezoeffekt-empfindlichen elektrischen Bauelemente 3 sind somit vor Piezoeffekten geschützt.

Die vierte Variante hat den Vorteil, dass die ganze spannungsfreie Parzelle 7 gegenüber dem restlichen Halbleitermaterial 1 gut elektrisch isoliert ist, wenn die stark verjüngten Zwischenstege 6 vollkommen aus Halbleitermaterial bestehen, welches vom entgegengesetzten Leitfähigkeitstyp ist wie das Halbleitermaterial 1, und die damit sowohl mit der isolierten Parzelle 7 als auch mit dem übrigen Halbleitermaterial 1 je ein P/N-Übergang bilden, wodurch eine fast perfekte elektrische Isolation der piezoeffekt-empfindlichen elektrischen Bauelemente 3 im Halbleitermaterial 1 erreicht wird. Die Zwischenstege 6 werden dann vorzugsweise als Wanne geformt, welche von der Oberfläche her in das Halbleitermaterial 1 eindiffundiert werden, und die Parzelle 7 wird bis auf die Wannen durch den Zwischenraum 4 freigesetzt.

In den Figuren 4 und 5 wurde beispielsweise angenommen, dass das Halbleitermaterial 1 vom Leitfähigkeitstyp N ist. Alle Wannen und alle Zwischenstege 6 bestehen dann aus einem vorzugsweise stark mit Fremdatomen, z.B. Boratomen, dotierten Halbleitermaterial vom Leitfähigkeitstyp P+. Die Konzentration Boratomen beträgt dabei z.B. ca. $10^{20}$ cm$^{-3}$.

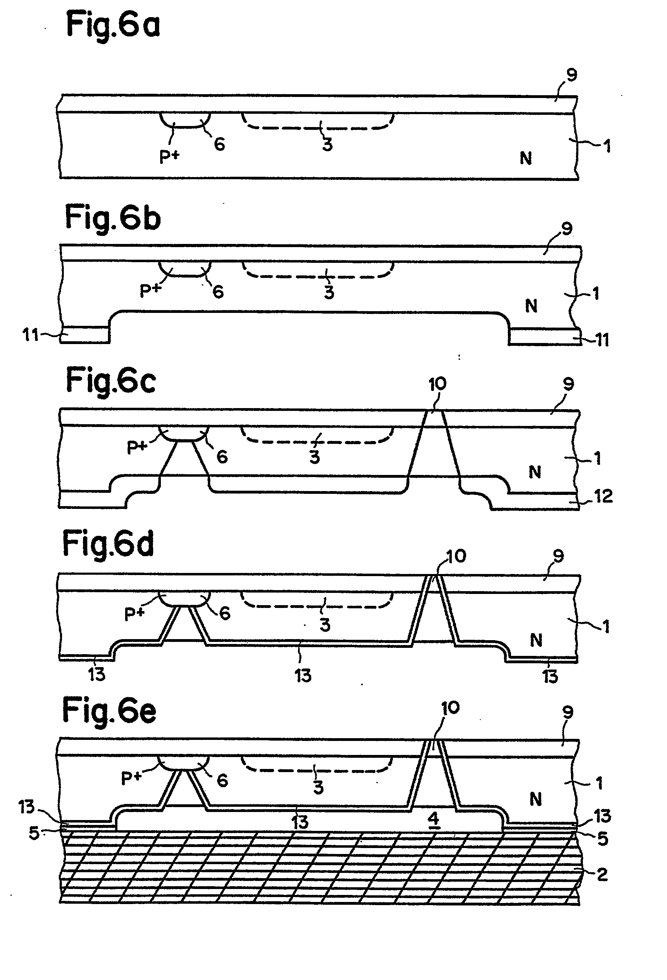

In den Figuren 6a bis 6e ist eine Möglichkeit dargestellt, wie die vierte Variante aus N-Siliziumhalbleitermaterial mit einem (100)-Wafermaterial hergestellt werden kann. Zuerst werden alle elektrischen Bauelemente bzw. wird deren integrierte Schaltung mit einer herkömlichen Technologie und auf an sich bekannte Weise an der Oberfläche in das Wafergrundmaterial eindiffundiert, welches das Halbleitermaterial 1 darstellt. Zu einem mit den Herstellungsschritten verträglichen Zeitpunkt werden um die mechanisch zu isolierenden elektrischen Bauelemente zwecks Realisierung der Zwischenstege 6 P+-Wannen eindiffundiert, welche dann die stark verjüngten Zwischenstege 6 und damit die zu isolierende Parzelle 7 definieren. Anschliessend werden auf bekannte Weise die nicht dargestellten Leiterbahnen 8 aufgetragen und die Oberfläche der Anordnung mit mindestens einer Passivierungsschicht 9 abgedeckt. Die so erhaltene Anordnung ist in der Fig. 6a dargestellt.

Nach Fertigung der eigentlichen integrierten Schaltung und deren Passivierung, d. h. mit einem Halbleitermaterial 1, in dem bereits alle elektrischen Bauelemente sowie alle Wannen des entgegengesetzten Leitfähigkeitstyps P+ eindiffundiert sind und dessen Oberfläche bereits mit Leiterbahnen 8 sowie mit mindestens einer Passivierungsschicht 9 versehen ist, wird in einem ersten Verfahrensschritt im Bereich der zu isolierenden Parzelle 7 mittels einer ersten Maske 11 aus belichtetem Photoresist-Material und eines isotropen Ätzverfahrens das Halbleitermaterial 1 von der Rückseite her geringfügig verjüngt, so dass die Parzelle 7 bei der späteren Montage auf das Trägermaterial 2 auf ihrer Rückseite nicht mitbefestigt wird. Die so erhaltene Anordnung ist in der Fig. 6b dargestellt.

Die erste Maske 11 wird anschliessend chemisch entfernt und durch eine zweite Maske 12 aus belichtetem Photoresist-Material ersetzt. Das so erhaltene Halbleitermaterial 1 wird in einem weiteren Verfahrensschritt wieder von der Rückseite her diesmal mittels eines anisotropem Ätzverfahrens behandelt und rund um die zu isolierende Parzelle 7 ausgehöhlt zwecks Erzeugung des seitlichen Zwischenraums 4 rund um die zu isolierende Parzelle 7. Die Wannen aus Halbleitermaterial des Leitfähigkeitstyps P+ wirken dabei als Ätzstopp und bilden die Zwischenstege 6, während an den Stellen, wo keine Wannen vorhanden sind, das Halbleitermaterial 1 und die Passivationsschicht 9 bis zur Oberfläche hin durchätzt werden, so dass Druckausgleichöffnungen 10 vom Zwischenraum 4 zur Oberfläche hin entstehen. Die so erhaltene Anordnung ist in der Fig. 6c dargestellt.

Nach dem Entfernen der zweiten Maske 12 wird zur elektrischen Isolation der Parzelle 7 in einem weiteren Verfahrensschritt die gesamte Rückseite des so erhaltenen Halbleitermaterials 1 noch mit einer dünnen Abdeckschicht 13 versehen, deren Leitfähigkeitstyp P entgegengesetzt dem Leitfähigkeitstyp N des Halbleitermaterials 1 ist. Die so erhaltene Anordnung ist in der Fig. 6d dargestellt.

In einem letzten Verfahrensschritt wird die so erhaltene Anordnung mit einer Schicht Verbindungsmaterial 5 auf das Trägermaterial 2 montiert, wodurch der Zwischenraum 4 nach unten hin geschlossen wird. Ist an der Oberfläche der Anordnung keine Druckausgleichöffnung 10 vorhanden, dann muss das Trägermaterial 2 mit mindestens einer solchen Druckausgleichöffnung 10 versehen werden, um im Zwischenraum 4 einen Druckausgleich zu gewährleisten. Die so erhatene Anordnung ist in der Fig. 6e dargestellt. Der Zwischenraum 4 ist in allen vier Varianten der erfindungsgemässen Anordnung mit Vakuum oder Gas, z. B. Luft gefüllt.

Für andere Ausgangsmaterialien und Orientierungen des Wafermaterials müssen die oben beschriebenen Verfahrensschritte entsprechend angepasst werden.

## Patentansprüche

1. Anordnung zur Verminderung von Piezoeffekten in mindestens einem in einem Halbleitermaterial (1) angeordneten piezoeffekt-empfindlichen elektrischen Bauelement (3), wobei das Halbleitermaterial (1) entlang einer Auflagefläche auf einem Trägermaterial (2) montiert ist, dadurch gekennzeichnet, dass nur ein Teil des Halbleitermaterials (1) mit dem piezoeffekt-empfindlichen elektrischen Bauelement (3) bzw. mit den piezoeffekt-empfindlichen elektrischen Bauelementen (3) belegt ist und dass zwischen diesem Teil des Halbleitermaterials (1) und dem zugehörigen Teil des Trägermaterials (2) ein Zwischenraum (4) vorhanden ist.

2. Anordnung nach Anspruch 1, dadurch gekennzeichnet, dass der Zwischenraum (4) derart ausgebildet ist, dass der Teil des Halbleitermaterials (1), der mit dem piezoeffekt-empfindlichen elektrischen Bauelement (3) bzw. mit den piezoeffekt-empfindlichen elektrischen Bauelementen (3) belegt ist, die gemeinsame Auflagefläche zwischen Halbleitermaterial (1) und Trägermaterial (2) balkonartig überragt.

3. Anordnung nach Anspruch 1 oder 2, dadurch gekennzeichnet, dass mindestens der Teil des Halbleitermaterials (1), der durch das piezoeffekt-empfindliche elektrische Bauelement (3) bzw. durch die piezoeffekt-empfindlichen Bauelemente (3) belegt ist, eine annähernd konstante Dicke aufweist.

4. Anordnung nach einem der Ansprüche 1 bis 3, dadurch gekennzeichnet, dass das Halbleitermaterial (1) mittels einer Schicht aus Verbindungsmaterial (5) auf dem Trägermaterial (2) entlang der gemeinsamen Auflagefläche montiert ist, wobei das Verbindungsmaterial (5) nur zwischen einem Teil des Trägermaterials (2) und einem zugehörigen Teil des Halbleitermaterials (1) angeordnet ist, der ausserhalb desjenigen Teils des Halbleitermaterials (1) gelegen ist, der das piezoeffekt-empfindliche elektrische Bauelement (3) bzw. die piezoeffekt-empfindlichen Bauelemente (3) enthält.

5. Anordnung nach Anspruch 4, dadurch gekennzeichnet, dass der Teil des Halbleitermaterials (1), der das piezoeffekt-empfindliche elektrische Bauelement (3) bzw. die piezoeffekt-empfindlichen elektrischen Bauelemente (3) enthält, mindestens leicht dünner ist als der übrige Teil des Halbleitermaterials (1).

6. Anordnung nach Anspruch 4, dadurch gekennzeichnet, dass das Halbleitermaterial (1) eine annähernd konstante Dicke aufweist.

7. Anordnung nach einem der Ansprüche 1 bis 5, dadurch gekennzeichnet, dass der Teil des Halbleitermaterials (1), der durch das piezoeffekt-empfindliche elektrische Bauelement (3) bzw. durch die piezoeffekt-empfindlichen elektrischen Bauelemente (3) belegt ist, über mindestens einen Zwischensteg (6) mit dem übrigen Teil des Halbleitermaterials (1) verbunden ist, wobei der Zwischensteg (6) bedeutend dünner ist als der Teil des Halbleitermaterials (1), der durch das piezoeffekt-empfindliche elektrische Bauelement (3) bzw. durch die piezoeffekt-empfindlichen elektrischen Bauelemente (3) belegt ist.

8. Anordnung nach Anspruch 1, dadurch gekennzeichnet, dass der Teil des Halbleitermaterials (1), der durch das piezoeffekt-empfindliche elektrische Bauelement (3) bzw. durch die piezoeffekt-empfindlichen elektrischen Bauelemente (3) belegt ist, eine Parzelle (7) im Halbleitermaterial (1) bildet, die mindestens leicht dünner ist als der übrige Teil des Halbleitermaterials (1), der seinerseits so auf das Trägermaterial (2) montiert ist, dass zwischen der Parzelle (7) und dem Trägermaterial (2) der Zwischenraum (4) vorhanden ist.

9. Anordnung nach Anspruch 8, dadurch gekennzeichnet, dass die Parzelle (7) auch seitlich mindestens teilweise von dem Zwischenraum (4) umgeben ist, der sie somit sowohl vom Trägermaterial (2) als auch mindestens teilweise vom übrigen Halbleitermaterial (1) trennt.

10. Anordnung nach Anspruch 8 oder 9, dadurch gekennzeichnet, dass die Parzelle (7) mindestens teilweise an der Oberfläche des Halbleitermaterials (1) eines bestimmten Leitfähigkeitstyps (N) von einem Halbleitermaterial eines entgegengesetzten Leitfähigkeitstyps (P) seitlich umgeben ist.

11. Anordnung nach Anspruch 10, dadurch gekennzeichnet, dass das Halbleitermaterial des entgegengesetzten Leitfähigkeitstyp (P) mindestens eine Wanne bildet, wobei jede Wanne an der Oberfläche in das Halbleitermaterial (1) eindiffundiert und bedeutend dünner ist als die Parzelle (7), so dass jede Wanne als Zwischensteg (6) der mechanischen Verbindung der Parzelle (7) zum übrigen Teil des Halbleitermaterials (1) dient.

12. Anordnung nach Anspruch 10 oder 11, dadurch gekennzeichnet, dass das Halbleitermaterial des entgegengesetzten Leitfähigkeitstyps (P) die Parzelle (7) seitlich nur teilweise umgibt und dass die Parzelle (7) für den verbleibenden Rest seitlich durch den Zwischenraum (4) vom restlichen Halbleitermaterial (1) getrennt ist.

13. Anordnung nach einem der Ansprüche 1 bis 12, dadurch gekennzeichnet, dass der Zwischenraum (4) mit Gas oder Vakuum gefüllt ist.

14. Anordnung nach einem der Angsprüche 1 bis 13, dadurch gekennzeichnet, dass der Zwischenraum (4) mit mindestens einer Druckausgleichöffnung (10) versehen ist.

15. Verfahren zur Realisierung einer Anordnung nach Anspruch 8, dadurch gekennzeichnet, dass mindestens in einem Verfahrensschritt mittels einer Maske (11) und eines isotropen Ätzverfahrens von der Rückseite her das Halbleitermaterial (1) im Bereich der zu isolierenden Parzelle (7) geringfügig verjüngt wird, so dass die Parzelle (7) bei der späteren Montage auf das Trägermaterial (2) auf ihrer Rückseite nicht mitbefestigt wird, und dass in einem weiteren Verfahrensschritt die so erhaltene Anordnung mit einer Schicht Verbindungsmaterial (5) auf das Trägermaterial (2) montiert wird, wodurch der Zwischenraum (4) zwischen der Parzelle (7) und dem Trägermaterial (2) entsteht.

16. Verfahren zur Realisierung einer Anordnung nach Anspruch 9 mit einem Halbleitermaterial (1), dadurch gekennzeichnet, dass mindestens in einem Verfahrensschritt mittels einer ersten Maske (11) und eines isotropen Ätzverfahrens von der Rückseite her das Halbleitermaterial (1) im Bereich der zu isolierenden Parzelle (7) geringfügig verjüngt wird, so dass die Parzelle (7) bei der späteren Montage auf das Trägermaterial (2) auf ihrer Rückseite nicht mitbefestigt wird, dass anschliessend nach dem Entfernen der ersten Maske (11) und einem Ersatz derselben durch eine zweite Maske (12) in einem zusätzlichen Verfahrensschritt von der Rückseite her das so erhaltene Halbleitermaterial (1) mittels eines anisotropen Ätzverfahrens rund um die zu isolierende Parzelle (7) ausgehöhlt wird, zwecks Erzeugung des seitlichen Zwischenraums (4), und dass in einem weiteren Verfahrensschritt die so erhaltene Anordnung mit einer Schicht Verbindungsmaterial (5) auf das Trägermaterial (2) montiert wird, wodurch der Zwischenraum (4) nach unten hin geschlossen wird.

17. Verfahren zur Realisierung einer Anordnung nach einem der Ansprüche 11 bis 14 mit einem Halbleitermaterial (1) eines bestimmten Leitfähigkeitstyps (N), in dem bereits alle Wannen des entgegengesetzten Leitfähigkeitstyps (P) eindiffundiert sind, dadurch gekennzeichnet, dass in einem Verfahrensschritt mittels einer ersten Maske (11) und eines isotropen Ätzverfahrens von der Rückseite her dieses Halbleitermaterial (1) im Bereich der zu isolierenden Parzelle (7) geringfügig verjüngt wird, so dass die Parzelle (7) bei der späteren Montage auf das Trägermaterial (2) auf ihrer Rückseite nicht mitbefestigt wird, dass anschliessend nach dem Entfernen der ersten Maske (11) und einem Ersatz derselben durch eine zweite Maske (12) in einem zusätzlichen Verfahrensschritt von der Rückseite her das so erhaltene Halbleitermaterial (1) mittels eines anisotropen Ätzverfahrens rund um die zu isolierende Parzelle (7) ausgehöhlt wird zwecks Erzeugung des seitlichen Zwischenraums (4), wobei die Wannen aus Halbleitermaterial des entgegengesetzten Leitfähigkeitstyps (P) als Ätzstopp wirken, während an den Stellen, wo keine Wannen vorhanden sind, das Halbleitermaterial (1) und eine Passivationsschicht (9) bis zur Oberfläche hin durchätzt werden, dass nach dem Entfernen der zweiten Maske (12) in einem weiteren zusätzlichen Verfahrensschritt die Rückseite des so erhaltenen Halbleitermaterials (1) noch mit einer dünnen Abdeckschicht (13) versehen wird, deren Leitfähigkeitstyp (P) entgegengesetzt dem Leitfähigkeitstyp (N) des Halbleitermaterials (1) ist, und dass in einem weiteren Verfahrensschritt die so erhaltene Anordnung mit einer Schicht Verbindungsmaterial (5) auf das Trägermaterial (2) montiert wird, wodurch der Zwischenraum (4) nach unten hin geschlossen wird.

## Claims

1. An arrangement for reducing piezoelectric effects in at least one piezoelectric effect-sensitive electrical component (3) arranged in a semiconductor material (1), wherein the semiconductor material (1) is mounted along a support surface on a carrier material (2), characterised in that only a part of the semiconductor material (1) is occupied by the piezoelectric effect-sensitive electrical component (3) or the piezoelectric effect-sensitive electrical components (3) and that there is an intermediate space (4) between said part of the semiconductor material (1) and the associated part of the carrier material (2).

2. An arrangement according to claim 1 characterised in that the intermediate space (4) is of such a configuration that the part of the semiconductor material (1) which is occupied by the piezoelectric effect-sensitive electrical component (3) or the piezoelectric effect-sensitive electrical components (3) projects in a balcony-like configuration beyond the common contact surface between the semiconductor material (1) and the carrier material (2).

3. An arrangement according to claim 1 or claim 2 characterised in that at least the part of the semiconductor material (1) which is occupied by the piezoelectric effect-sensitive electrical component (3) or by the piezoelectric effect-sensitive components (3) is of approximately constant thickness.

4. An arrangement according to one of claims 1 to 3 characterised in that the semiconductor material (1) is mounted on the carrier material (2) along the common contact surface by means of a layer of connecting material (5), wherein the connecting material (5) is arranged only between a part of the carrier material (2) and an associated part of the semiconductor material (1) which is disposed outside that part of the semiconductor material (1) which contains the piezoelectric effect-sensitive electrical component (3) or the piezoelectric effect-sensitive components (3).

5. An arrangement according to claim 4 characterised in that the part of the semiconductor material (1) which contains the piezoelectric effect-sensitive electrical component (3) or the piezoelectric effect-sensitive electrical components (3) is at least slightly thinner than the remaining part of the semiconductor material (1).

6. An arrangement according to claim 4 characterised in that the semiconductor material (1) is of an approximately constant thickness.

7. An arrangement according to one of claims 1 to 5 characterised in that the part of the semiconductor material (1) which is occupied by the piezoelectric effect-sensitive electrical component (3) or by the piezoelectric effect-sensitive electrical components (3) is connected to the remaining part of the semiconductor material (1) by way of at least one intermediate limb portion (6), wherein the intermediate limb portion (6) is significantly thinner than the part of the semiconductor material (1) which is occupied by the piezoelectric effect-sensitive electrical component (3) or by the piezoelectric effect-sensitive electrical components (3).

8. An arrangement according to claim 1 characterised in that the part of the semiconductor material (1) which is occupied by the piezoelectric effect-sensitive electrical component (3) or by the piezoelectric effect-sensitive electrical components (3) forms in the semiconductor material (1) a parcel (7) which is at least slightly thinner than the remaining part of the semiconductor material (1), which in turn is so mounted on the carrier material (2) that the intermediate space (4) is between the parcel (7) and the carrier material (2).

9. An arrangement according to claim 8 characterised in that the parcel (7) is also laterally at least partially surrounded by the intermediate space (4) which therefore separates it both from the carrier material (2) and also at least partially from the remaining semiconductor material (1).

10. An arrangement according to claim 8 or claim 9 characterised in that the parcel (7) is laterally surrounded at least partially at the surface of the semiconductor material (1) of a given conductivity type (N), by a semiconductor material of an opposite conductivity type (P).

11. An arrangement according to claim 10 characterised in that the semiconductor material of the opposite conductivity type (P) forms at least one trough, wherein each trough is diffused into the semiconductor material (1) at the surface and is significantly thinner than the parcel (7) so that each trough serves as an intermediate limb portion (6) of the mechanical connection of the parcel (7) to the remaining part of the semiconductor material (1).

12. An arrangement according to claim 10 or claim 11 characterised in that the semiconductor material of the opposite conductivity type (P) laterally only partially surrounds the parcel (7) and that for the remaining part the parcel (7) is laterally separated from the remaining semiconductor material (1) by the intermediate space (4).

13. An arrangement according to one of claims 1 to 12 characterised in that the intermediate space (4) is filled with gas or vacuum.

14. An arrangement according to one of claims 1 to 13 characterised in that the intermediate space (4) is provided with at least one pressure equalising opening (10).

15. A process for the production of an arrangement according to claim 8 characterised in that the semiconductor material (1) is slightly thinned from the back in the region of the parcel (7) to be isolated at least in one process step by means of a mask (11) and an isotropic etching process, so that in the subsequent assembly operation the parcel (7) is not also fixed on its back on to the carrier material (2) and that in a further process step the resulting arrangement is mounted on the carrier material (2), with a layer of connecting material (5), whereby the intermediate space (4) is formed between the parcel (7) and the carrier material (2).

16. A process for the production of an arrangement according to claim 9 with a semiconductor material (1) characterised in that the semiconductor material (1) is slightly thinned from the back in the region of the parcel (7) to be isolated at least in one process step by means of a first mask (11) and an isotropic etching process, so that in the subsequent assembly operation the parcel (7) is not also fixed on its back on to the carrier material (2), that then after removal of the first mask (11) and replacement thereof by a second mask (12), in an additional process step, the resulting semiconductor material (1) is hollowed out from the back around the parcel (7) to be isolated, by means of an anisotropic etching process, for the purposes of producing the lateral intermediate space (4), and that in a further process step the resulting arrangement is mounted on the carrier material (2), with a layer of connecting material (5), whereby the intermediate space (4) is closed downwardly.

17. A process for the production of an arrangement according to one of claims 11 to 14 with a semiconductor material (1) of a given conductivity type (N) in which all troughs of the opposite conductivity type (P) are already diffused therein, characterised in that in a process step the semiconductor material (1) is slightly thinned from the back in the region of the parcel (7) to be isolated by means of a first mask (11) and an isotropic etching process, so that in the subsequent assembly operation the parcel (7) is not also fixed on its back on to the carrier material (2), that then after removal of the first mask (11) and replacement thereof by a second mask (12), in an additional process step, the resulting semiconductor material (1) is hollowed out from the back around the parcel (7) to be isolated, by means of an anisotropic etching process, for the purposes of producing the lateral intermediate space (4), wherein the troughs of semiconductor material of the opposite conductivity type (P) act as an etching stop, while at the locations where there are no troughs the semiconductor material (1) and a passivation layer (9) are etched through as far as the surface, that after removal of the second mask (12), in a further additional process step, the back of the resulting semiconductor material (1) is also provided with a thin cover layer (13), the conductivity type (P) of which is opposite to the conductivity type (N) of the semiconductor material (1), and that in a further process step the resulting arrangement is mounted on to the carrier material (2) with a layer of connecting material (5), whereby the intermediate space (4) is closed downwardly.

## Revendications

1. Dispositif destiné à réduire les effets piézo-électriques dans au moins un composant électrique (3) sensible à l'effet piézo-électrique contenu dans une matière semiconductrice (1), la matière semiconductrice (1) étant montée sur une matière support (2) le long d'une surface de portée, caractérisé en ce que seule une partie de la matière semiconductrice (1) est occupée par le composant électrique (3) sensible à l'effet piézoélectrique ou par les composants électriques (3) sensibles à l'effet piézo-électrique et en ce qu'un espace intercalaire (4) est présent entre cette partie de la matière semiconductrice (1) et la partie correspondante de la matière support (2).

2. Dispositif selon la revendication 1, caractérisé en ce que l'espace intercalaire (4) est configuré de telle manière que la partie de la matière semiconductrice (1) qui est occupée par le composant électrique (3) sensible à l'effet piézo-électrique ou par les composants électriques (3) sensibles à l'effet piézo-électrique, surplombe en balcon la surface de portée commune entre la matière semiconductrice (1) et la matière support (2).

3. Dispositif selon la revendication 1 ou 2, caractérisé en ce qu'au moins la partie de la matière semiconductrice (1) qui est occupée par le composant électrique (3) sensible à l'effet piézo-électrique ou par les composants (3) sensibles à l'effet piézo-électrique possède une épaisseur à peu près constante.

4. Dispositif selon une des revendications 1 à 3, caractérisé en ce que la matière semiconductrice (1) est montée sur la matière support (2), le long de la surface de portée commune, à l'aide d'une couche de matière de liaison (5), la matière de liaison (5) étant disposée uniquement entre une partie de la matière support (2) et une partie correspondante de la matière semiconductrice (1) qui est située en dehors de la partie de la matière semiconductrice (1) qui contient le composant électrique (3) sensible à l'effet piézo-électrique ou les composants électriques (3) sensibles à l'effet piézo-électrique.

5. Dispositif selon la revendication 4, caractérisé en ce que la partie de la matière semiconductrice (1) qui contient le composant électrique (3) sensible à l'effet piézo-électrique ou les composants électriques (3) sensibles à l'effet piézo-électrique est au moins légèrement plus mince que la partie restante de la matière semiconductrice (1).

6. Dispositif selon la revendication 4, caractérisé en ce que la matière semiconductrice (1) présente une épaisseur à peu près constante.

7. Dispositif selon une des revendications 1 à 5, caractérisé en ce que la partie de la matière semiconductrice (1) qui est occupée par le composant électrique (3) sensible à l'effet piézo-électrique ou par les composants électriques (3) sensibles à l'effet piézo-électrique est reliée à la partie restante de la matière semiconductrice (1) par au moins un voile intermédiaire (5), le voile intermédiaire (6) étant beaucoup plus mince que la partie de la matière semiconductrice (1) qui est occupée par le composant électrique (3) sensible à l'effet piézo-électrique ou par les composants électriques (3) sensibles à l'effet piézo-électrique.

8. Dispositif selon la revendication 1, caractérisé en ce que la partie de la matière semiconductrice (1) qui est occupée par le composant électrique (3) sensible à l'effet piézo-électrique ou par les composants électriques (3) sensibles à l'effet piézo-électrique forme une parcelle (7) dans la matière semiconductrice (1), qui est au moins légèrement plus mince que la partie restante de la matière semiconductrice (1), partie restante qui est de son côté montée sur la matière support (2) de telle manière qu'il subsiste un espace intercalaire (4) entre la parcelle (7) et la matière support (2).

9. Dispositif selon la revendication 8, caractérisé en ce que la parcelle (7) est aussi entourée latéralement, du moins en partie, par l'espace intercalaire (4) qui la sépare ainsi aussi bien de la matière support (2) que, du moins partiellement, du reste de la matière semiconductrice (1).

10. Dispositif selon la revendication 8 ou 9, caractérisé en ce que la parcelle (7) est entourée latéralement, du moins en partie, au niveau de la surface de la matière semiconductrice (1), qui est d'un type de conductivité déterminé (N), est entourée latéralement d'une matière semiconductrice possédant un type de conductivité opposé (P).

11. Dispositif selon la revendication 10, caractérisé en ce que la matière semiconductrice du type de conductivité opposé (P) forme au moins une cuvette, chaque cuvette étant diffusée dans la matière semiconductrice (1) au niveau de la surface et étant beaucoup plus mince que la parcelle (7), de sorte que chaque cuvette sert de voile intermédiaire (6) constituant la liaison mécanique entre la parcelle (7) et la partie restante de la matière semiconductrice (1).

12. Dispositif selon la revendication 10 ou 11, caractérisé en ce que la matière semiconductrice du type de conductivité (P) n'entoure latéralement la parcelle (7) qu'en partie et en ce que, pour le reste, la parcelle (7) est séparée latéralement de la matière semiconductrice (1) restante par l'espace intercalaire (4).

13. Dispositif selon une des revendications 1 à 12, caractérisé en ce que l'espace intercalaire (4) est remoli de gaz ou de vide.

14. Dispositif selon une des revendications 1 à 13, caractérisé en ce que l'espace intercalaire (4) est muni d'au moins une ouverture d'équilibrage des pressions (10).

15. Procédé de réalisation d'un dispositif selon la revendication 8, caractérisé en ce qu'au moins dans une étape du procédé, on amincit légèrement la matière semiconductrice (1), en agissant sur sa face dorsale, dans la région de la parcelle (7) qu'il s'agit d'isoler, à l'aide d'un masque (11) et en appliquant un procédé de gravure isotrope, de sorte que, au cours du montage ultérieur sur la matière support (2), la parcelle (7) n'est pas fixée comme le reste au niveau de sa face arrière et en ce que, dans une étape suivante du procédé, le dispositif ainsi obtenu est monté sur la matière support (2) à l'aide d'une couche de matière de liaison (5), de sorte que l'espace intercalaire (4) se forme entre la parcelle (7) et la matière support (2).

16. Procédé de réalisation d'un dispositif selon la revendication 9, qui comprend une matière semiconductrice (1), caractérisé en ce qu'au moins dans une étape du procédé, on amincit légèrement la matière semiconductrice (1) sur sa face dorsale, dans la région de la parcelle (7) qu'il s'agit d'isoler, à l'aide d'un premier masque (11) et en appliquant un procédé de gravure isotrope, de sorte que, lors du montage ultérieur sur la matière support (2), la parcelle (7) n'est pas fixée comme le reste au niveau de sa face dorsale, en ce que, ensuite, après l'élimination du premier masque (11) et le remplacement de ce masque par un deuxième masque (12), et dans une étape additionnelle du procédé, la matière semiconductrice (1) ainsi obtenue est creusée, en agissant sur sa face dorsale, sur tout le tour de la parcelle (7) qu'il s'agit d'isoler, par application d'un procédé de gravure anisotrope, pour former l'espace intercalaire latéral (4) et en ce que, dans une autre étape du procédé, le dispositif ainsi obtenu est monté sur la matière support (2) à l'aide d'une couche de matière de liaison (5), ce qui a pour effet de fermer l'espace intercalaire (4) vers le bas.

17. Procédé de réalisation d'un dispositif selon une des revendications 11 à 14, comprenant une matière semiconductrice (1) possédant un type de conductivité donné (N), et dans laquelle toutes les cuvettes du type de conductivité opposé (P) sont déjà diffusées, caractérisé en ce que, dans une étape du procédé, et en agissant à l'aide d'un premier masque (11) et en appliquant un procédé de gravure isotrope, on amincit légèrement cette matière semiconductrice (1) sur sa face dorsale, dans la région de la parcelle (7) qu'il s'agit d'isoler, de sorte qu'au cours du montage ultérieur sur la matière support (2), la parcelle (7) n'est fixée pas comme le reste au niveau de sa face dorsale, en ce que, ensuite, après avoir éliminé le premier masque (11) et remplacé ce masque par un deuxième masque (12), et dans une étape additionnelle du procédé, la matière semiconductrice (1) ainsi obtenue est creusée sur sa face dorsale, tout autour de la parcelle (7) qu'il s'agit d'isoler, par application d'un procédé de gravure anisotrope, pour produire l'espace intercalaire latéral (4), les cuvettes de matière semiconductrice du type de conductivité opposé (P) se comportant comme un arrêt de gravure, tandis que, aux endroits où il n'existe pas de cuvette, la matière semiconductrice (1) et une couche de passivation (9) sont traversées par la gravure jusqu'à la surface, en ce que, après l'élimination du deuxième masque (12), et dans une autre étape additionnelle du procédé, on munit la face dorsale de la matière semiconductrice (1) ainsi obtenue d'une mince couche de recouvrement (13) dont le type de conductivité (P) est l'opposé du type de conductivité (N) de la matière semiconductrice (1) et en ce que, dans une autre étape du procédé, on monte le dispositif ainsi obtenu sur la matière support (2) à l'aide d'une couche de matière de liaison (5), de sorte que l'espace intercalaire (4) est ainsi fermé vers le bas.

# Fig. 1

# Fig. 2

# Fig. 3

# Fig. 4

# Fig. 5

# Fig.6a

# Fig.6b

# Fig.6c

# Fig.6d

# Fig.6e